# EUROPEAN PATENT APPLICATION

(11) **EP 4 553 511 A1**
(43) Date of publication of application: **14.05.2025**
(21) Application number: 23856026.2
(22) Date of filing: 10.03.2023
(51) Int. Cl.: G01R 31/26, H02P 6/08, H02P 29/024, H02P 29/032, F04B 49/06

(54) **SIGNAL DETECTION CIRCUIT, DETECTION METHOD, MOTOR CONTROLLER, COMPRESSOR AND VEHICLE**

(30) Priority: 25.08.2022 CN 202211026023
(71) Applicant: Anhui Welling Auto Parts Corporation Limited, Hefei, Anhui 230088 (CN); Guangdong Welling Auto Parts Corporation Limited, Foshan, Guangdong 528311 (CN)
(72) Inventor: QIN, Feixiang, Hefei, Anhui 230088 (CN); SHI, Hongkang, Hefei, Anhui 230088 (CN); SONG, Wanjie, Hefei, Anhui 230088 (CN); LI, Junlong, Hefei, Anhui 230088 (CN); LI, Yudong, Hefei, Anhui 230088 (CN)
(74) Representative: Ran, Handong
(86) International application number: PCT/CN2023/080869
(87) International publication number: WO 2024/040929

(57) **Abstract**

A signal detection circuit, a detection method, a motor controller, a compressor, and a vehicle. The circuit (100) comprises: a lower bridge driving unit (110), used to output a first fault detection signal; an upper bridge driving unit (120), used to output a second fault detection signal; a switch unit (130), used to disconnect transmission of the second fault detection signal in a phase when a lower bridge switch tube is connected to charge a bootstrap and negative voltage capacitor of the upper bridge driving unit; and a control unit (140), used to control the switch unit to disconnect transmission of the second fault detection signal, and when charging of the bootstrap and negative voltage capacitor of the upper bridge driving unit is complete, control the switch unit to be connected, so as to simultaneously receive the first fault detection signal and the second fault detection signal.

## Description

### CROSS-REFERENCE TO RELATED APPLICATION

The present application claims priority to Chinese patent application No. 202211026023.0, titled "SIGNAL DETECTION CIRCUIT, DETECTION METHOD, MOTOR CONTROLLER, COMPRESSOR AND VEHICLE", and filed on August 25, 2022, the entire contents of which are incorporated herein by reference.

### FIELD

The present disclosure relates to the technical field of electronic circuits, and in particular, to a signal detection circuit, a detection method, a motor controller, a compressor, and a vehicle.

### BACKGROUND

The third generation semiconductor typified by the silicon carbide (SiC) has broad application prospects in various fields such as electric vehicles because of its higher switching frequency, higher voltage and temperature resistances, lower loss under the same operation conditions, and smaller volume than the silicon (Si) device under the same performance.

### SUMMARY

The present disclosure aims to solve at least one of the technical problems in the related art to a certain extent. To this end, a first objective of the present disclosure is to provide a fault protection signal detection circuit.

A second objective of the present disclosure is to provide a motor controller.

A third objective of the present disclosure is to provide a compressor.

A fourth objective of the present disclosure is to provide a vehicle.

A fifth objective of the present disclosure is to provide a method for detecting a fault protection signal.

To achieve the above objectives, embodiments in a first aspect of the present disclosure provide a fault protection signal detection circuit. The circuit includes: a lower bridge driving unit configured to drive a lower bridge switch transistor to turn on or turn off, and output a first fault detection signal by detecting whether the lower bridge switch transistor fails; an upper bridge driving unit configured to drive an upper bridge switch transistor to turn on or turn off, and output a second fault detection signal by detecting whether the upper bridge switch transistor fails; a switch unit configured to turn off transmission of the second fault detection signal during charging of a bootstrap capacitor and a negative voltage capacitor of the upper bridge driving unit when the lower bridge switch transistor is turned on; and a control unit configured to drive the lower bridge switch transistor to turn on through the lower bridge driving unit to charge the bootstrap capacitor and the negative voltage capacitor of the upper bridge driving unit, control the switch unit to turn off the transmission of the second fault detection signal, and control the switch unit to turn on to simultaneously receive the first fault detection signal and the second fault detection signal when the charging of the bootstrap capacitor and the negative voltage capacitor of the upper bridge driving unit is completed.

To achieve the above objectives, embodiments in a second aspect of the present disclosure provide a motor controller including a three-phase inverter bridge and the fault protection signal detection circuit according to the embodiments in the first aspect of the present disclosure.

To achieve the above objectives, embodiments in a third aspect of the present disclosure provide a compressor including a motor and the motor controller according to the embodiments in the second aspect of the present disclosure. The motor controller is configured to drive the motor to operate.

To achieve the above objectives, embodiments in a fourth aspect of the present disclosure provide a vehicle including the compressor according to embodiments in the third aspect of the present disclosure.

To achieve the above objectives, embodiments in a fifth aspect of the present disclosure provide a method for detecting a fault protection signal. The method is applied to the above-described motor controller and includes: driving, when the motor controller is powered on, the lower bridge switch transistor to turn on through the lower bridge driving unit, to charge the bootstrap capacitor and the negative voltage capacitor of the upper bridge driving unit, and controlling the switch unit to turn off transmission of the second fault detection signal; and controlling the switch unit to turn on to simultaneously receive the first fault detection signal and the second fault detection signal when charging of the bootstrap capacitor and the negative voltage capacitor of the upper bridge driving unit is completed.

Additional aspects and advantages of the present disclosure will be provided at least in part in the following description, or will become apparent at least in part from the following description, or can be learned from practicing of the present disclosure.

### BRIEF DESCRIPTION OF THE DRAWINGS

FIG. 1 is a schematic block diagram of a fault protection signal detection circuit according to an embodiment of the present disclosure.
FIG. 2 and FIG. 3 each are a circuit diagram of a fault signal detection circuit according to an embodiment of the present disclosure.
FIG. 4 is a schematic block diagram of a motor controller according to an embodiment of the present disclosure.
FIG. 5 is a schematic block diagram of a compressor according to an embodiment of the present disclosure.
FIG. 6 is a schematic block diagram of a vehicle according to an embodiment of the present disclosure.
FIG. 7 is a schematic flowchart of a method for detecting a fault protection signal according to an embodiment of the present disclosure.

### DETAILED DESCRIPTION OF THE EMBODIMENTS

Embodiments of the present disclosure will be described in detail below with reference to examples thereof as illustrated in the accompanying drawings, throughout which same or similar elements, or elements having same or similar functions, are denoted by same or similar reference numerals. The embodiments described below with reference to the drawings are illustrative only, and are intended to explain, rather than limit, the present disclosure.

It should be noted that, an electric vehicle is provided with a motor and a motor controller. The motor controller includes a three-phase inverter bridge including a SiC and other power devices, a driving chip with a bootstrap capacitor and a negative voltage capacitor, and a Micro Controller Unit (MCU). The MCU outputs a driving signal to the driving chip, which drives the three-phase inverter bridge to operate, so as to drive the motor to operate. In a case of a power device failure, such as a short circuit overcurrent fault, the driving chip is required to turn off the power device in time and output a fault signal to the MCU, in such a manner that the MCU can play a protective role based on the fault signal, preventing escalation of the fault. However, in an initial state, the bootstrap capacitor and the negative voltage capacitor in the driving chip need to be charged. In this case, the driving chip continuously outputs the fault signal to the MCU, which results in erroneous protection of the MCU, causing the motor controller to fail to operate normally. Based on this, embodiments of the present disclosure provide a fault protection signal detection circuit, which can not only save IO resources, but also avoid occurrence of the situation in which the controller is unable to operate normally due to a fault detection signal output by an upper bridge driving unit during charging.

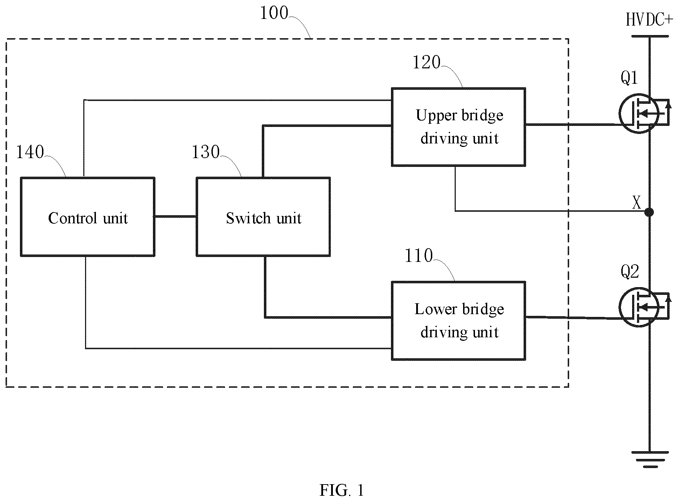

FIG. 1 is a block diagram of a fault protection signal detection circuit according to an embodiment of the present disclosure.

As illustrated in FIG. 1, the fault protection signal detection circuit 100 includes a lower bridge driving unit 110, an upper bridge driving unit 120, a switch unit 130, and a control unit 140.

The lower bridge driving unit 110 is configured to drive a lower bridge switch transistor Q2 to turn on or turn off, and output a first fault detection signal by detecting whether the lower bridge switch transistor Q2 fails. The upper bridge driving unit 120 is configured to drive an upper bridge switch transistor Q1 to turn on or turn off and output a second fault detection signal by detecting whether the upper bridge switch transistor Q1 fails. The switch unit 130 is configured to turn off transmission of the second fault detection signal during charging of a bootstrap capacitor and a negative voltage capacitor of the upper bridge driving unit 120 when the lower bridge switch transistor Q2 is turned on. The control unit 140 is configured to drive the lower bridge switch transistor Q2 to turn on through the lower bridge driving unit 110 to charge the bootstrap capacitor and the negative voltage capacitor of the upper bridge driving unit 120, control the switch unit 130 to turn off the transmission of the second fault detection signal, and control the switch unit 130 to turn on to simultaneously receive the first fault detection signal and the second fault detection signal when the charging of the bootstrap capacitor and the negative voltage capacitor of the upper bridge driving unit 120 is completed.

It should be noted that, a bridge arm formed by the upper bridge switch transistor Q1 and the lower bridge switch transistor Q2 that are connected in series as illustrated in FIG. 1 may be a bridge arm of a three-phase inverter bridge in a motor controller, but the embodiments of the present disclosure is not limited thereto. For convenience of description, the motor controller is taken as an example for explanation below.

During initialization of the motor controller, since the upper bridge driving unit 120 has a bootstrap capacitor and a negative voltage capacitor, the bootstrap capacitor and the negative voltage capacitor in the upper bridge driving unit 120 need to be charged. In this case, the control unit 140 outputs a driving signal to the lower bridge driving unit 110, which drives the lower bridge switch transistor Q2 to turn on. The upper bridge driving unit 120 charges the internal bootstrap capacitor and the negative voltage capacitor through a node X and the lower bridge switch transistor Q2. During charging, the upper bridge driving unit 120 continuously outputs the second fault detection signal (indicating that a negative voltage does not reach a threshold) and inputs the second fault detection signal to the switch unit 130. To prevent the second fault detection signal from being transmitted to the control unit 140, which results in erroneous protection of the control unit 140, the control unit 140 controls the switch unit 130 to turn off, to stop the transmission of the second fault detection signal, which avoid erroneous protection during the charging, preventing the motor controller from being unable to operating normally.

When charging of the bootstrap capacitor and the negative voltage capacitor of the upper bridge driving unit 120 is completed, the control unit 140 controls the switch unit 130 to turn on. Since the upper bridge driving unit 120 stops outputting the second fault detection signal after the charging is completed, the erroneous protection of the control unit 140 is not caused. It should be noted that, whether charging of the upper bridge driving unit 120 is completed may be determined by the control unit 140 based on empirical data, theoretical data, or the like. For example, when a charging process of the upper bridge driving unit 120 requires about 300 us (the charging duration is not limited thereto, and may be specifically determined according to actual situations), the switch unit 130 may be controlled to turn on after 300 us.

Then, the motor controller enters a normal operation stage. The control unit 140 outputs the driving signal to each of the upper bridge driving unit 120 and the lower bridge driving unit 110 according to control demands, and drives the upper bridge switch transistor Q1 and the lower bridge switch transistor Q2 to turn on or turn off through the upper bridge driving unit 120 and the lower bridge driving unit 110. During this period, the upper bridge driving unit 120 further detects whether the upper bridge switch transistor Q1 fails, and outputs the second fault detection signal when the upper bridge switch transistor Q1 fails (for example, a short circuit overcurrent fault may occur). At the same time, the lower bridge driving unit 110 also detects whether the lower bridge switch transistor Q2 fails, and outputs the first fault detection signal when the lower bridge switch transistor Q2 fails. The first fault detection signal and the second fault detection signal may be transmitted to the control unit 140 through the switch unit 130, in such a manner that the control unit 140 performs protection according to the first fault detection signal and the second fault detection signal, for example, stops outputting the driving signal to the upper bridge driving unit 120 and the lower bridge driving unit 110. Therefore, protection of the upper bridge switch transistor Q1 and the lower bridge switch transistor Q2 is realized, which further protects the motor controller.

In the above embodiment, since the switch unit simultaneously receives the first fault detection signal and the second fault detection signal and transmits them to the control unit, input/output (IO) occupation of the control unit may be reduced, saving IO resources. At the same time, the transmission of the second fault detection signal is stopped by turning off the switch unit during the charging of the upper bridge driving unit, in such a manner that occurrence of a situation in which the controller is unable to operate normally due to the fault detection signal output by the upper bridge driving unit during charging may be avoided.

In some embodiments, the switch unit 140 is further configured to receive the first fault detection signal during the charging of the bootstrap capacitor and the negative voltage capacitor of the upper bridge driving unit 120 when the lower bridge switch transistor Q2 is turned on.

For example, during the charging of the upper bridge driving unit 120, since the lower bridge driving unit 110 does not need to use the bootstrap capacitor, the first fault detection signal is transmitted to the switch unit 130 when the lower bridge driving unit 110 detects that the lower bridge switch transistor Q2 fails. In this case, the switch unit 130 is allowed to transmit the first fault detection signal to the control unit 140. Therefore, when the lower bridge switch transistor Q2 fails, the control unit 140 is capable of making corresponding protection to avoid an accident caused by a fault of the lower bridge switch transistor Q2 during the charging of the upper bridge driving unit 120.

In some embodiments, the lower bridge driving unit 110 drives the lower bridge switch transistor Q2 to turn off when detecting that the lower bridge switch transistor Q2 fails. The upper bridge driving unit 120 drives the upper bridge switch transistor Q1 to turn off when detecting that the upper bridge switch transistor Q1 fails. The control unit 140 stops outputting the driving signal to the lower bridge driving unit 120 and the upper bridge driving unit 110 when determining that the lower bridge switch transistor Q2 or the upper bridge switch transistor Q1 fails according to the first fault detection signal and the second fault detection signal.

For example, during the initialization of the motor controller, when the lower bridge switch transistor Q2 fails, the lower bridge driving unit 110 detects the fault, drives the lower bridge switch transistor Q2 to turn off based on the fault, and outputs the first fault detection signal to the switch unit 130, which transmits the first fault detection signal to the control unit 140. In response to receiving the first fault detection signal, the control unit 140 stops outputting the driving signal to the lower bridge driving unit 120.

During the normal operation of the motor controller, when the lower bridge switch transistor Q2 fails, the lower bridge driving unit 110 detects the fault, drives the lower bridge switch transistor Q2 to turn off based on the fault, and outputs the first fault detection signal to the switching unit 130, which transmits the first fault detection signal to the control unit 140. In response to receiving the first fault detection signal, the control unit 140 stops outputting the driving signals to the lower bridge driving unit 120 and the upper bridge driving unit 110 to protect the motor controller. Similarly, when the upper bridge switch transistor Q1 fails, the upper bridge driving unit 120 detects the fault, drives the upper bridge switch transistor Q1 to turn off based on the fault, and outputs the second fault detection signal to the switching unit 130, which transmits the second fault detection signal to the control unit 140. In response to receiving the second fault detection signal, the control unit 140 stops outputting the driving signals to the lower bridge driving unit 120 and the upper bridge driving unit 110 is stopped to protect the motor controller.

In this way, the motor controller can be protected both during the charging and during the normal operation.

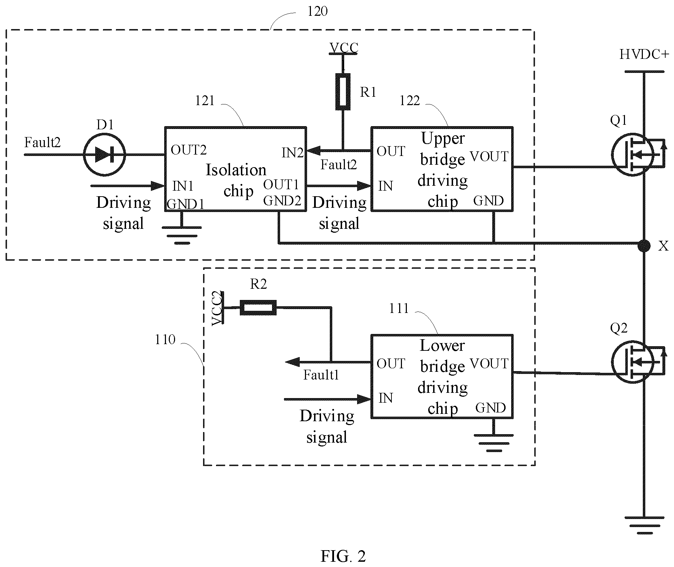

In some embodiments, as illustrated in FIG. 2, the upper bridge driving unit 120 includes an isolation chip 121, a first diode D1, and an upper bridge driving chip 122. A first input pin IN1 of the isolation chip 121 is connected to an upper bridge driving signal output terminal of the control unit 140. An anode of the first diode D1 serves as a fault protection signal output terminal of the upper bridge driving unit 120, and a cathode of the first diode D1 is connected to a first output pin OUT2 of the isolation chip 121. An input pin IN of the upper bridge driving chip 122 is connected to a second output pin OUT1 of the isolation chip 121, an output pin OUT of the upper bridge driving chip 122 is connected to a second input pin IN2 of the isolation chip 121 and is connected to a first predetermined power supply VCC1 through a first pull-up resistor R1, and a driving output pin VOUT of the upper bridge driving chip 122 is connected to a control terminal of the upper bridge switch transistor Q1.

As illustrated in FIG. 2, the lower bridge driving unit 110 includes a lower bridge driving chip 111. An output pin OUT of the lower bridge driving chip 111 is connected to a second predetermined power supply VCC2 through a second pull-up resistor R2 and serves as a fault protection signal output terminal of the lower bridge driving unit 110, an input pin IN of the lower bridge driving chip 111 is connected to a lower bridge driving signal output terminal of the control unit 140, and a driving output pin VOUT of the lower bridge driving chip 111 is connected to a control terminal of the lower bridge switch transistor Q2.

For example, since the upper bridge switch transistor Q1 corresponds to a high-voltage side, the upper bridge driving unit 120 adopts an isolation driving scheme to isolate a high-voltage signal from a low-voltage signal on a side of the switch unit 130 and the control unit 140, preventing the high-voltage signal from affecting the low-voltage signal. The lower bridge switch transistor Q2 corresponds to a low-voltage side, thus the lower bridge driving unit 110 may adopt a non-isolation driving scheme.

The upper bridge driving chip 122 and the lower bridge driving chip 111 each are a chip with bootstrap, negative voltage, desaturation and detection functions. For example, when a short circuit fault occurs in the upper bridge switch transistor Q1, the upper bridge driving chip 122 detects the fault and performs hardware turn-off, and outputs a second fault detection signal Fault2 to the isolation chip 121. The second fault detection signal Fault2 is transmitted to the switch unit 130 after isolation by the isolation chip 121, and then transmitted to the control unit 140 for the control unit 140 to perform protection. When a short circuit fault occurs in the lower bridge switch transistor Q2, the lower bridge driving chip 111 detects the fault and performs hardware turn-off, outputs a first fault detection signal Fault1 to the switch unit 130. The first fault detection signal Fault1 is then transmitted to the control unit 140 for the control unit 140 to perform protection.

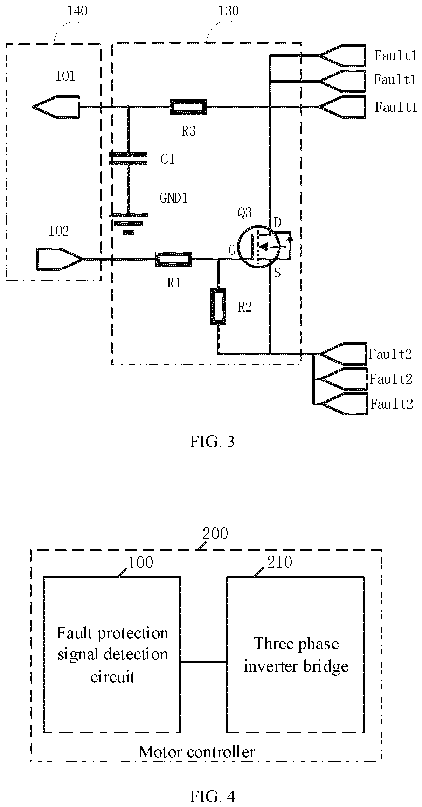

In some embodiments, the switch unit 130 includes any one of a transistor, a MOS transistor, a silicon controlled rectifier, and an IGBT. As illustrated in FIG. 3, when the switch unit 130 includes an NMOS transistor Q3, a drain of the NMOS transistor Q3 is connected to the fault protection signal output terminal of the lower bridge driving unit 110, a source of the NMOS transistor Q3 is connected to the fault protection signal output terminal of the upper bridge driving unit 120, and a gate of the NMOS transistor Q3 is connected to a control signal output terminal IO2 of the control unit 140.

Further, as illustrated in FIG. 3, the switch unit 130 further includes: a first resistor R1 and a second resistor R2. The first resistor R1 is connected between the gate of the NMOS transistor Q3 and the control signal output terminal IO2 of the control unit 140. The second resistor R2 is connected between the gate and the source of the NMOS transistor Q3. The first resistor R1 is a gate driving resistor of the NMOS transistor Q3. The second resistor R2 is a pull-down resistor for ensuring that the NMOS transistor Q3 can be reliably driven.

The switch unit 130 further includes a third resistor R3 and a first capacitor C1. The third resistor R3 is connected between the drain of the NMOS transistor Q3 and the signal input terminal IO1 of the control unit 140. The first capacitor C1 has a terminal connected to the signal input terminal IO1 of the control unit 140 and another terminal grounded GND1. The third resistor R3 and the first capacitor C1 constitute a low-pass filter circuit, for which different stop frequencies may be set by selecting different parameters, for performing filtering processing on the first fault detection signal Fault1.

For example, the upper bridge driving chip 122 and the lower bridge driving chip 111 generally output fault detection signals in the following situations. 1) The negative voltage does not reach a threshold. 2) The forward voltage does not reach the threshold (an under-voltage situation). 3) Overcurrent occurs in switch transistors.

As illustrated in FIG. 2 and FIG. 3, during the initialization of the motor controller, the bootstrap capacitor and the negative voltage capacitor in the upper bridge driving unit 120 need to be charged. In this case, the control unit 140 outputs the driving signal to the lower bridge driving unit 111 to control the lower bridge switch transistor Q2 to turn on through the lower bridge driving unit 111. The upper bridge driving unit 120 charges the internal bootstrap capacitor and the negative voltage capacitor through the node X and the lower bridge switch transistor Q2. During this period, since the negative voltage does not reach the threshold, the upper bridge driving chip 122 continuously outputs the second fault detection signal Fault2 of a low level to the isolation chip 121, and the second fault detection signal Fault2 is transmitted to the switch unit 130 through the isolation chip 121 and the first diode D1. Meanwhile, the control unit 140 outputs a control signal of a low level to the NMOS transistor Q3 in the switch unit 130 through the control signal output terminal IO2 to turn the NMOS transistor Q3 off. In this case, the second fault detection signal Fault2 of the low level fails to enter the signal input terminal IO1 of the control unit 140 through the NMOS transistor Q3, thus the control unit 140 does not perform protection. Since the lower bridge driving chip 111 does not need the bootstrap capacitor, the lower bridge driving chip 111 outputs the first fault detection signal Fault1 of a low level to the switch unit 130 when the lower bridge switch transistor Q2 fails (for example, overcurrent occurs in the lower bridge switch transistor Q2). Since there is no limitation by the NMOS transistor Q3, the first fault detection signal Fault1 of the low level directly enters the signal input terminal IO1 of the control unit 140. When the control unit 140 receives the first fault detection signal Fault1 of the low level, the control unit 140 stops outputting the driving signal to the lower bridge switch transistor Q2, etc., to protect the motor controller.

When charging of the upper bridge driving chip 122 is completed, for example, after 100ms, the control unit 140 outputs the control signal of a high level to the NMOS transistor Q3 through the control signal output terminal IO2 to turn on the NMOS transistor Q3, and the upper bridge driving chip 122 outputs the second fault detection signal Fault2 of a high level. The motor controller enters the normal operation stage. During this stage, the upper bridge driving chip 122 outputs the second fault detection signal Fault2 of the low level when detecting that the upper bridge switch transistor Q1 fails. The second fault detection signal Fault2 of the low level passes through the isolation chip 121, the first diode D1, and the NMOS transistor Q3, and then enters the signal input terminal IO1 of the control unit 140. In response to receiving the second fault detection signal Fault2 of the low level, the control unit 140 stops outputting the driving signals to the upper bridge switch transistor Q1 and the lower bridge switch transistor Q2, etc. to protect the motor controller. Similarly, the lower bridge driving chip 111 outputs the first fault detection signal Fault1 of the low level when detecting that the lower bridge switch transistor Q2 fails. The first fault detection signal Fault1 of the low level enters the signal input terminal IO1 of the control unit 140. In response to receiving the first fault detection signal Fault1 of the low level, the control unit 140 stops outputting the driving signals to the upper bridge switch transistor Q1 and the lower bridge switch transistor Q2, etc., to protect the motor controller. In an embodiment, the control unit 140 may transmit the first fault detection signal Fault1 of the low level and the second fault detection signal Fault2 of the low level to a master computer to provide a user with a reminder, which may include a fault type reminder or the like.

In the above embodiments, the fault signals of the upper bridge switch transistor and the lower bridge switch transistor may be detected through one IO port. In addition, since the upper bridge driving chip with the bootstrap capacitor and the negative voltage capacitor needs to establish a voltage at an initial power-on stage, the upper bridge driving chip continuously outputs the fault signal during this period. When there is no restriction from the switch unit, the fault signal is detected after initialization of the control unit is completed, which causes the motor controller to fail to operate normally. However, through the restriction from the switch unit, this stage can be avoided. The restriction from the switch unit is released when the charging of the upper bridge driving chip is completed, and the fault signal is detected, avoiding occurrence of the situation in which the controller is unable to operate normally due to the fault detection signal output by the upper bridge driving unit during charging. Also, a structure is simple, which may enable program configuration to be concise and efficient.

It should be noted that, the above description is only about detection of the fault signals of the upper bridge switch transistor and the lower bridge switch transistor of one bridge arm, but the present disclosure is not limited to one bridge arm in practical application. For example, the three-phase inverter bridge includes three bridge arms. Each of the three bridge arms includes the upper bridge switch transistor and the lower bridge switch transistor. In this case, an upper bridge driving unit may be provided for each upper bridge switch transistor, and a lower bridge driving unit may be provided for each lower bridge switch transistor. Second fault detection signals Fault2 corresponding to three upper bridge switch transistors are input to the switch unit 130 in parallel, and First fault detection signals Fault1 corresponding to three lower bridge switch transistors are input to the switch unit 130 in parallel. In an embodiment, as illustrated in FIG. 3, six fault detection signals may be detected through one IO port by using the switch unit 130, which effectively saves IO resources, and avoids occurrence of the situation in which the controller is unable to operate normally due to the fault detection signal output by the upper bridge driving unit during charging. In this way, software control is simplified, saving resources of the control unit. In addition, FIG. 3 is only an exemplary specification, and the circuit structure may be simply modified, such as mirroring the circuit structure or using other switching transistors, all of which are all within the protection scope of the present disclosure. Further, the first diode D1 may play an isolation role. For example, when a bridge arm of the three-phase inverter bridge fails, a fault detection signal of a low level is output. Due to the existence of the first diode D1, fault detection signals of other bridge arms are not pulled down.

In summary, the fault protection signal detection circuit is provided according to the embodiments of the present disclosure. The lower bridge driving unit drives the lower bridge switch transistor to turn on or turn off, and outputs the first fault detection signal when detecting that the lower bridge switch transistor fails. The upper bridge driving unit drives the upper bridge switch transistor to turn on or turn off, and outputs the second fault detection signal when detecting that the upper bridge switch transistor fails. The switch unit is controlled to turn off transmission of the second fault detection signal during charging of the bootstrap capacitor and the negative voltage capacitor of the upper bridge driving unit when the lower bridge switch transistor is turned on when driven by the lower bridge driving unit. The switch unit is controlled to turn on to simultaneously receive the first fault detection signal and the second fault detection signal when the charging of the bootstrap capacitor and the negative voltage capacitor of the upper bridge driving unit is completed. In this way, not only can IO resources be saved, but also the occurrence of the situation in which the controller is unable to operate normally due to the fault detection signal output by the upper bridge driving unit during charging can be avoided.

In some embodiments, a motor controller is further provided.

As illustrated in FIG. 4, a motor controller 200 includes a three-phase inverter bridge 210 and the above-described fault protection signal detection circuit 100. The fault protection signal detection circuit 100 drives the lower bridge switch transistor in the three-phase inverter bridge 210 to turn on or turn off through the lower bridge driving unit, outputs the first fault detection signal when detecting that the lower bridge switch transistor fails, drives the upper bridge switch transistor in the three-phase inverter bridge 210 to turn on or turned off through the upper bridge driving unit, outputs the second fault detection signal when detecting that the upper bridge switch transistor fails; controls the switch unit to turn off the transmission of the second fault detection signal during charging of the bootstrap capacitor and the negative voltage capacitor of the upper bridge driving unit when the lower bridge switch transistor is turned on by the lower bridge driving unit, and controls the switch unit to turn on to simultaneously receive the first fault detection signal and the second fault detection signal when the charging of the bootstrap capacitor and the negative voltage capacitor of the upper bridge driving unit is completed.

With the motor controller according to the embodiments of the present disclosure, the above-described fault protection signal detection circuit can not only save IO resources, but also avoid occurrence of a situation in which the controller is unable to operate normally due to the fault detection signal output by the upper bridge driving unit during charging.

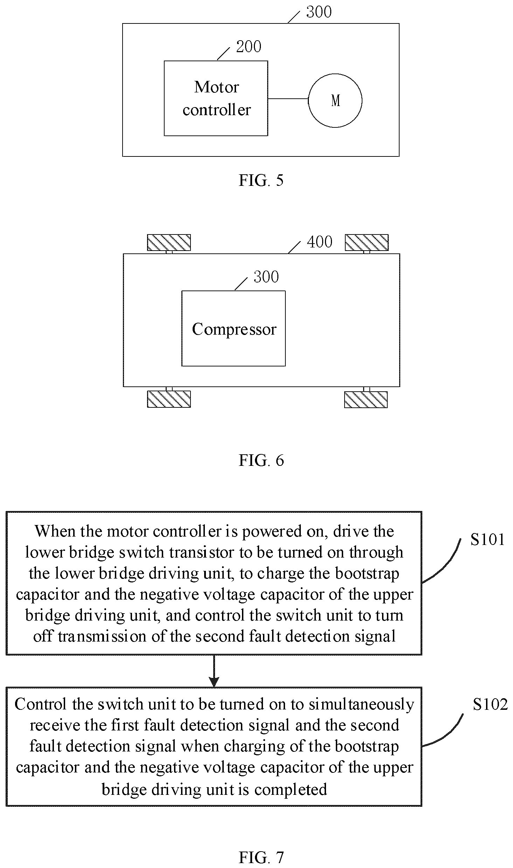

In some embodiments, a compressor is further provided. As illustrated in FIG. 5, the compressor 300 includes a motor M and the above-described motor controller 200. The motor controller 200 is configured to drive the motor M to operate.

In some embodiments, the compressor 300 may be an electric compressor including a driving portion and a compression portion. The driving portion of the electric compressor drives the compression portion to perform compression. For example, the driving portion may include the motor M including a rotor and a stator, and the above-described motor controller 200. The motor controller 200 drives the motor M to operate to drive the compression portion to perform compression. In addition, in some embodiments, the electric compressor may be a low back pressure compressor. The driving portion may be disposed in a low-pressure chamber communicating with an intake port of the compressor. The compression portion may be disposed in a high-pressure chamber communicating with an exhaust port of the compressor. Further, in some embodiments, the electric compressor may be a horizontal compressor. The driving portion and the compression portion may be arranged in a lateral direction, and the like.

When the motor controller 200 drives the motor M to operate to drive the compression portion to perform compression, the fault protection signal detection circuit in the motor controller 200 drives the lower bridge switch transistor in the three-phase inverter bridge to turn on or turn off through the lower bridge driving unit, outputs the first fault detection signal when detecting that the lower bridge switch transistor fails, drives the upper bridge switch transistor in the three-phase inverter bridge to turn on or turn off through the upper bridge driving unit, and outputs the second fault detection signal when detecting that the upper bridge switch transistor fails; controls the switch unit to turn off transmission of the second fault detection signal during charging of the bootstrap capacitor and the negative voltage capacitor of the upper bridge driving unit when the lower bridge switch transistor is turned on through the lower bridge driving unit, and controls the switch unit to turn on to simultaneously receive the first fault detection signal and the second fault detection signal when the charging of the bootstrap capacitor and the negative voltage capacitor of the upper bridge driving unit is completed.

With the compressor according to the embodiments of the present disclosure, the above-described motor controller can not only save IO resources, but also avoid occurrence of a situation in which the controller is unable to operate normally due to the fault detection signal output by the upper bridge driving unit during charging.

In some embodiments, a vehicle is also provided. As illustrated in FIG. 6, the vehicle 400 includes the above-described compressor 300.

In the embodiments of the present disclosure, the vehicle 400 includes the compressor 300 described in any of the above embodiments. The vehicle 400 may be a new energy vehicle. In some embodiments, the new energy vehicle may be a pure electric vehicle with an electric motor as a main driving force. In other embodiments, the new energy vehicle may be a hybrid vehicle with both an internal combustion engine and the electric motor as the main driving force. With regard to the internal combustion engine and the motor that provide driving power for the new energy vehicle mentioned in the above-described embodiments, gasoline, diesel, hydrogen, etc. may be used as a fuel for the internal combustion engine, and a power battery, a hydrogen fuel cell, etc. may be used for providing electric energy for the motor, which are not particularly limited herein. It should be noted that, this is only an exemplary description of a structure of the new energy vehicle and the like, and is not intended to limit the protection scope of the present disclosure.

With the vehicle according to the embodiments of the present disclosure, the above-described compressor can not only save IO resources, but also avoid occurrence of a situation in which the controller is unable to operate normally due to the fault detection signal output by the upper bridge driving unit during charging, which impedes normal operation of the vehicle.

In some embodiments, a method for detecting a fault protection signal is further provided.

The method is applied to the above-described motor controller. As illustrated in FIG. 7, the method may include operations at blocks S101 and S102.

At block S101, when the motor controller is powered on, the lower bridge switch transistor is driven to turn on through the lower bridge driving unit, to charge the bootstrap capacitor and the negative voltage capacitor of the upper bridge driving unit, and the switch unit is controlled to turn off transmission of the second fault detection signal.

At block S102, the switch unit is controlled to turn on to simultaneously receive the first fault detection signal and the second fault detection signal when charging of the bootstrap capacitor and the negative voltage capacitor of the upper bridge driving unit is completed.

It should be noted that, for other specific implementations of the method for detecting the fault protection signal according to the embodiments of the present disclosure, reference may be made to specific implementations of the fault protection signal detection circuit according to the above embodiments of the present disclosure.

The method for detecting the fault protection signal is provided according to the embodiments of the present disclosure. When the motor controller is powered on, the lower bridge switch transistor is driven to turn on through the lower bridge driving unit, to charge the bootstrap capacitor and the negative voltage capacitor of the upper bridge driving unit, and the switch unit is controlled to turn off transmission of the second fault detection signal. The switch unit is controlled to turn on to simultaneously receive the first fault detection signal and the second fault detection signal when charging of the bootstrap capacitor and the negative voltage capacitor of the upper bridge driving unit is completed. In this way, not only can IO resources be saved, but also occurrence of a situation in which the controller is unable to operate normally due to the fault detection signal output by the upper bridge driving unit during charging can be avoided.

It should be noted that, the logic and/or step described in other manners herein or shown in the flow chart, for example, a particular sequence table of executable instructions for realizing the logical function, may be specifically achieved in any computer readable medium to be used by the instruction execution system, device or equipment (such as the system based on computers, the system comprising processors or other systems capable of obtaining the instruction from the instruction execution system, device and equipment and executing the instruction), or to be used in combination with the instruction execution system, device and equipment. As to the specification, "the computer readable medium" may be any device adaptive for including, storing, communicating, propagating or transferring programs to be used by or in combination with the instruction execution system, device or equipment. More specific examples of the computer readable medium comprise but are not limited to: an electronic connection (an electronic device) with one or more wires, a portable computer enclosure (a magnetic device), a random access memory (RAM), a read only memory (ROM), an erasable programmable read-only memory (EPROM or a flash memory), an optical fiber device and a portable compact disk read-only memory (CDROM). In addition, the computer readable medium may even be a paper or other appropriate medium capable of printing programs thereon, this is because, for example, the paper or other appropriate medium may be optically scanned and then edited, decrypted or processed with other appropriate methods when necessary to obtain the programs in an electric manner, and then the programs may be stored in the computer memories.

It should be understood that each part of the present disclosure may be realized by the hardware, software, firmware or their combination. In the above embodiments, a plurality of steps or methods may be realized by the software or firmware stored in the memory and executed by the appropriate instruction execution system. For example, if it is realized by the hardware, likewise in another embodiment, the steps or methods may be realized by one or a combination of the following techniques known in the art: a discrete logic circuit having a logic gate circuit for realizing a logic function of a data signal, an application-specific integrated circuit having an appropriate combination logic gate circuit, a programmable gate array (PGA), a field programmable gate array (FPGA), etc.

Reference throughout this specification to "an embodiment", "some embodiments", "an example", "a specific example", or "some examples" means that a particular feature, structure, material, or characteristic described in connection with the embodiment or example is included in at least one embodiment or example of the present disclosure. In this specification, exemplary descriptions of aforesaid terms do not necessarily refer to the same embodiment or example. Further, the particular features, structures, materials, or characteristics may be combined in any suitable manner in one or more embodiments or examples.

In addition, the terms "first" and "second" used in the embodiments of the present disclosure are only used for descriptive purposes, and cannot be understood as indicating or implying relative importance, or implicitly indicating the number of technical features indicated in the embodiments. Therefore, the features associated with "first" and "second" may explicitly or implicitly include at least one of the features. In the description of the present disclosure, "plurality" means at least two or two and more, e.g., two, three, four, etc., unless otherwise specifically defined.

Although embodiments of the present disclosure have been illustrated and described above, it should be understood that the above embodiments are merely exemplary, and cannot be construed to limit the present disclosure. For those skilled in the art, changes, modifications, substitutions, and variations can be made to the embodiments without departing from the scope of the present disclosure.

## Claims

1. A fault protection signal detection circuit, comprising:
a lower bridge driving unit configured to drive a lower bridge switch transistor to turn on or turn off, and output a first fault detection signal by detecting whether the lower bridge switch transistor fails;
an upper bridge driving unit configured to drive an upper bridge switch transistor to turn on or turn off, and output a second fault detection signal by detecting whether the upper bridge switch transistor fails;
a switch unit configured to turn off transmission of the second fault detection signal during charging of a bootstrap capacitor and a negative voltage capacitor of the upper bridge driving unit when the lower bridge switch transistor is turned on; and
a control unit configured to drive the lower bridge switch transistor to turn on through the lower bridge driving unit to charge the bootstrap capacitor and the negative voltage capacitor of the upper bridge driving unit, control the switch unit to turn off the transmission of the second fault detection signal, and control the switch unit to turn on to simultaneously receive the first fault detection signal and the second fault detection signal when the charging of the bootstrap capacitor and the negative voltage capacitor of the upper bridge driving unit is completed.

2. The circuit according to claim 1, wherein the control unit is further configured to receive the first fault detection signal during the charging of the bootstrap capacitor and the negative voltage capacitor of the upper bridge driving unit when the lower bridge switch transistor is turned on.

3. The circuit according to claim 1 or 2, wherein:
the lower bridge driving unit drives the lower bridge switch transistor to turn off when detecting that the lower bridge switch transistor fails;
the upper bridge driving unit drives the upper bridge switch transistor to turn off when detecting that the upper bridge switch transistor fails; and
the control unit turns off driving signals outputted to the lower bridge driving unit and the upper bridge driving unit when determining that the lower bridge switch transistor or the upper bridge switch transistor fails according to the first fault detection signal and the second fault detection signal.

4. The circuit according to any one of claims 1 to 3, wherein the switch unit comprises any one of a transistor, a MOS transistor, a silicon controlled rectifier, and an IGBT.

5. The circuit according to claim 4, wherein when the switch unit comprises an NMOS transistor, a drain of the NMOS transistor is connected to a fault protection signal output terminal of the lower bridge driving unit, a source of the NMOS transistor is connected to a fault protection signal output terminal of the upper bridge driving unit, and a gate of the NMOS transistor is connected to a control signal output terminal of the control unit.

6. The circuit according to claim 5, wherein the switch unit further comprises:
a first resistor connected between the gate of the NMOS transistor and the control signal output terminal of the control unit; and
a second resistor connected between the gate and the source of the NMOS transistor.

7. The circuit according to claim 5 or 6, wherein the switch unit further comprises:
a third resistor connected between the drain of the NMOS transistor and a signal input terminal of the control unit; and
a first capacitor having a terminal connected to the signal input terminal of the control unit and another terminal grounded.

8. The circuit according to any one of claims 1 to 7, wherein the upper bridge driving unit comprises:
an isolation chip, a first input pin of the isolation chip connected to an upper bridge driving signal output terminal of the control unit;
a first diode, an anode of the first diode serving as a fault protection signal output terminal of the upper bridge driving unit, and a cathode of the first diode connected to a first output pin of the isolation chip; and
an upper bridge driving chip, an input pin of the upper bridge driving chip connected to a second output pin of the isolation chip, an output pin of the upper bridge driving chip connected to a second input pin of the isolation chip and connected to a first predetermined power supply through a first pull-up resistor, and a driving output pin of the upper bridge driving chip connected to a control terminal of the upper bridge switch transistor.

9. The circuit according to any one of claims 1 to 8, wherein the lower bridge driving unit comprises a lower bridge driving chip, an output pin of the lower bridge driving chip connected to a second predetermined power supply through a second pull-up resistor and serving as a fault protection signal output terminal of the lower bridge driving unit, an input pin of the lower bridge driving chip connected to a lower bridge driving signal output terminal of the control unit, and a driving output pin of the lower bridge driving chip connected to a control terminal of the lower bridge switch transistor.

10. A motor controller, comprising:
a three-phase inverter bridge; and
the fault protection signal detection circuit according to any one of claims 1 to 9.

11. A compressor, comprising:
a motor; and
the motor controller according to claim 10, the motor controller configured to drive the motor to operate.

12. A vehicle, comprising the compressor according to claim 11.

13. A method for detecting a fault protection signal, wherein the method is applied to the motor controller according to claim 10 and comprises:
when the motor controller is powered on, driving the lower bridge switch transistor to turn on through the lower bridge driving unit, to charge the bootstrap capacitor and the negative voltage capacitor of the upper bridge driving unit, and controlling the switch unit to turn off transmission of the second fault detection signal; and
controlling the switch unit to turn on to simultaneously receive the first fault detection signal and the second fault detection signal when charging of the bootstrap capacitor and the negative voltage capacitor of the upper bridge driving unit is completed.
